(19) Europäisches Patentamt
European Patent Office
Office européen des brevets

(11) **EP 1 850 429 B1**

(12) **EUROPEAN PATENT SPECIFICATION**

(45) Date of publication and mention
of the grant of the patent:
**19.01.2011 Bulletin 2011/03**

(51) Int Cl.:
***H01S 5/0625*** (2006.01)

(21) Application number: **07105929.9**

(22) Date of filing: **11.04.2007**

(54) **Laser emission device with distributed reflectors**

Laserabstrahlungsvorrichtung mit verteilten Reflektoren

Dispositif d'émission laser doté de réflecteurs distribués

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **28.04.2006 FR 0651510**

(43) Date of publication of application:
**31.10.2007 Bulletin 2007/44**

(73) Proprietor: **Alcatel Lucent**
**75008 Paris (FR)**

(72) Inventor: **Debregeas-Sillard, Hélène**
**78150, LE CHESNAY (FR)**

(74) Representative: **Shamsaei Far, Hassan et al**
**Alcatel Lucent**
**IP&S**
**32 Avenue Kléber**
**92707 Colombes (FR)**

(56) References cited:
**FR-A1- 2 737 942   GB-A- 2 381 123**
**US-A- 5 088 097**

• **ALIBERT G ET AL: "A NEW TUNABLE LASER USING A SINGLE ELECTROABSORPTION TUNING SUPER STRUCTURE GRATING FOR SUBNANOSECOND SWITCHING APPLICATIONS" IEEE JOURNAL OF SELECTED TOPICS IN QUANTUM ELECTRONICS, IEEE SERVICE CENTER, PISCATAWAY, NJ, US, vol. 3, no. 2, April 1997 (1997-04), pages 598-606, XP000735960 ISSN: 1077-260X**

**EP 1 850 429 B1**

**Description**

This invention relates to a laser emission device with distributed reflector, also known as a Distributed Bragg Reflector laser or DBR laser, and particularly to such a laser emission device with a variable wavelength.

There are many applications for tuneable lasers. In an optical network, a tuneable laser can be used as a replacement component. Since it can be substituted selectively for several non-tuneable sources, it can reduce the number of immobilised protective components, and simplify stock procurement and management procedures. It can also be used to make a wavelength switch for a spectral multiplexing network.

Patent US-A-4885753 describes a tuneable DBR laser comprising a sequence of several gratings with different periods. In this device, gratings are built so that they can be weakly coupled to the laser cavity if there is no current injection. Current injection at each grating increases the coupling coefficient of the grating with light guided in the laser cavity. In order to obtain a significant variation of the coupling coefficient, light distribution between two superposed wave guides has to be varied because current injection only produces small variations in the absolute value of the index. This structure increases requirements in terms of manufacturing tolerances of the device. Furthermore, when coupling is carried out, the semiconducting material is already saturated or almost saturated, which only leaves a small variation range to adjust the Bragg wavelength of the grating. This device therefore results in a very narrow spectral interval for each grating.

Patent FR-A-2737942 describes a DBR laser that comprises a wave guide in which a plurality of elementary Bragg gratings are formed corresponding to determined Bragg wavelengths. Elementary sections of the Bragg section are voltage controlled to create optical absorption rather than a variation in the index. The laser emission wavelength is adjusted to one of the Bragg wavelengths of these elementary sections. Thus, this device enables adjustment of the wavelength for only a certain number of discrete values, and provided that there is an equal number of separate gratings, in the form of a sequence of elementary sections repeated several times. The resulting long length has disadvantages, as it increases losses and encourages mode skips.

GB-A-2381123, on which the preamble of claim 1 is based, discloses a tuneable laser comprising a plurality of discrete grating units with different pitches. Each grating unit has a pair of electrodes operable to reduce a reflective peak of the grating.

One purpose of this invention is to provide a laser emission device that can be tuned to several wavelengths, either discretely or continuously. Another purpose of the invention is to provide a laser emission device that can be tuned to a wide range of wavelengths. Another purpose of the invention is to provide a laser emission device that can be tuned quickly and easily. Another purpose of the invention is to provide a tuneable laser emission device that is easy to manufacture and control.

To achieve this, the invention describes a laser emission device as claimed in claim 1.

One concept on which the invention is based is to provide several distributed reflectors that are coupled to optical modes guided in a wave guide forming the laser cavity. Thus, the reflectors do not have to be coupled with the guided modes electrically and current injection at each distributed reflector can be used to modify the resonance wave length of the reflector within a wide range, for example more than 10 nm, or even around 15 nm, through modification of the index. Another concept on which the invention is based is to structurally create an optical reflectivity at a grating far from the active section of the laser that is higher than the optical reflectivity at a grating closer to the active section of the laser, such that by default the laser radiation condition is satisfied over a spectral band corresponding to the far grating. The reflectivity of the far grating must dominate in at least one of the closer grating's adjustment states, and preferably independently of the closer grating's adjustment state for reasons of simplicity. Another concept on which the invention is based is to control the reflecting function of the far grating like a two-state switch, so as to obtain very simple control of the device.

In the first reflecting unit, each grating produces a resonant reflectivity associated with its spatial period. The value of this resonant reflectivity may be adjusted using several physical grating parameters, particularly the length, the effective index, the geometry of the etching, the grating filling factor, etc. Preferably, distributed reflectors are formed such that the coupling coefficient of the second distributed reflector with the guided mode in the second wave guide portion is greater than a coupling coefficient of the first distributed reflector with the guided mode in the second wave guide portion.

According to one particular embodiment, the second wave guide portion comprises a guide layer made of a material with a high index between two layers of material with a lower index. Either the first or the second said distributed reflector, or both, may comprise an etched grating in the guide layer along its two longitudinal edges. One way of controlling the coupling coefficient is to vary the etching depth of the grating in the lateral direction of the guide layer.

For example, the coupling coefficient of the first distributed reflector is chosen to be greater than 10 cm$^{-1}$ and the coupling coefficient of the second distributed reflector is chosen to be greater than 60 cm$^{-1}$.

Preferably, the second spatial period is greater than the first spatial period. Since material absorption is lower for a long wavelength, this arrangement can make losses in the first reflecting device lower than they would be in a converse arrangement. The converse arrangement is also possible and may be preferred, depending on the requirements of the target application.

Advantageously, a controlled extinguishing means can be used to selectively generate optical absorption at the second distributed reflector. According to one particular embodiment, the extinguishing means includes a voltage source to apply a voltage with a polarity opposite to the polarity to the second control signal at the second distributed reflector. By combining dominating reflectivity in the spectral band associated with the reflector furthest from the amplification section of the device and a means of extinguishing this reflector, it is easy to obtain a source with an adjustable wavelength in at least two intervals: the wavelength is in an interval associated with the spatial period of the far reflector when the extinguishing means is not active, and the wavelength is within an interval associated with the spatial period of the closer reflector when the extinguishing means is active. The two wavelengths may be adjusted, for example by current injection. The extinguishing means can therefore perform the function of a two-state switch in which each state corresponds to a spectral interval.

Advantageously, an electrical adjustment means is provided capable of generating the first electrical signal to adjust the position of the first spectral band in the first spectral interval. According to one particular embodiment, the first electrical signal is a controlled current.

Advantageously, an electrical adjustment means is provided capable of generating the second electrical control signal to adjust the position of the second spectral band in the second spectral interval. According to one particular embodiment, the second electrical signal is a controlled current.

Preferably, the first and second spectral intervals are approximately adjacent or overlap. Thus, the device has an approximately continuous adjustment range extending over the two spectral intervals. Conversely, a laser device with two discontiguous emission ranges could be made.

According to one particular embodiment, a control unit is provided capable of selectively controlling the extinguishing means and the electrical adjustment means such that the extinguishing means is active in the first operating mode, and the electrical adjustment means of the first spectral band adjusts the position of the first spectral band to a wavelength to be emitted located in the first spectral interval, and in a second operating mode, the extinguishing means is inactive and the electrical adjustment means of the second spectral band adjusts the position of the second spectral band to a wavelength to be emitted located in the second spectral interval.

The second wave guide portion may be made in the form of a unit structure or several sub-structures optically coupled in series. Preferably, the second wave guide portion is formed so as to confine a very substantial portion of the light.

The invention will be better understood and other purposes, details, specific features and advantages of it will become clearer after reading the following description of several particular embodiments of the invention, given solely for illustrative purposes and in no way limitatively, with reference to the appended figures, wherein:

- figure 1 is a diagrammatic view showing a longitudinal section through a laser emission device according to a first embodiment of the invention,
- figure 2 is a view similar to that shown in figure 1 showing a laser emission device according to other embodiments of the invention,
- figure 3 shows adjustment ranges of the emission wavelength of the device in figure 1,
- figure 4 shows control signals of the device in figure 1 in two operating modes,
- figure 5 shows the spectral reflectivity of a passive section of the device in figure 1, for several example embodiments of Bragg reflectors,
- figure 6 shows wavelength tuning curves of a laser emission device according to one embodiment of the invention,
- figure 7 shows a partial perspective view of a grating being manufactured according to one particular embodiment,
- figure 8 shows a graph representing a coupling coefficient of the grating in figure 7.

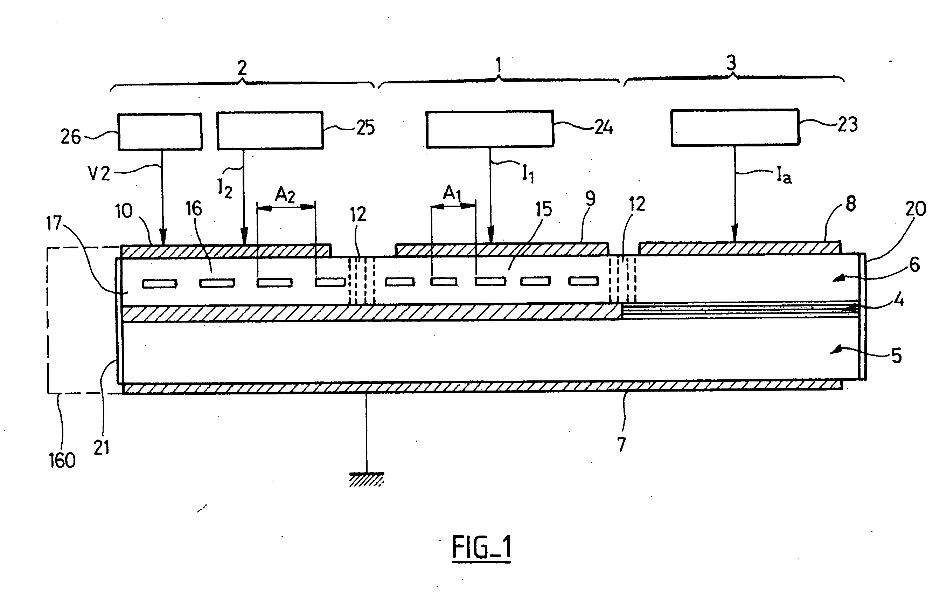

A first embodiment of a DBR tuneable laser source is shown diagrammatically on figure 1. This is a monolithic semiconducting component typically composed of an active section 3 that includes an amplifying medium, and a passive section, in this case composed of two Bragg sections 1 and 2 coupled in series to the active section. Each of the three sections has the structure of a wave guide, with a guide layer 4 with a relatively high index between two cladding layers 5 and 6 with a relatively low index.

For example, the guide layer 4 of the active section 3 may be composed of a sequence of quantum wells separated by layers forming a potential barrier. The cladding layers 5 and 6 may be formed of InP materials with opposite doping, using known technique. Thus, the structure of the multi-layer is a semiconducting junction like a diode.

Electrodes are provided so that an independent current can be injected in each section. A mass electrode 7 extends over the entire lower face of the cladding layer 5. Three electrodes 8, 9 and 10 extend on the cladding layer 6, adjacent to the active section 3 and the two Bragg sections 1 and 2 respectively. An insulating barrier 12 is provided between each section to form electrical insulation, for example in the form of protons implanted in the cladding layer 6.

A control module 23 controls the current la injected in the active section 3. A control module 24 controls the current 11 injected in the Bragg section 1. A control module 25 controls the current 12 injected in the Bragg section 2. A control module 26 has the special feature that it can apply a voltage V2 with a polarity opposite to the current I2 on the Bragg section 2, in other words it can bias the diode inversely to create absorption.

Each of the Bragg sections 1 and 2 is a reflecting section with a grating coupled to the wave guide to have resonant reflectivity, at least for one wavelength. Each Bragg section therefore forms a reflector with a selective wavelength and with a maximum reflection peak around the Bragg wavelength ai given by the formula:

$$ai = 2 \, Ni.Ai$$

where ai represents a wavelength in a vacuum, Ni represents the effective index seen by guided mode at the Bragg section and Ai represents the period of the grating at the Bragg section for i=1 or 2.

In the example shown, the gratings 15 and 16 are floating gratings. To achieve this, the cladding layer 6 is formed in several steps. A spacing layer 17 made of a material with a low index, for example InP, is formed above the guide layer 4. A grating layer with a high index is deposited on the layer 17, for example made of a quaternary material InGaAsP. Part of this grating layer is then eliminated by known etching techniques, so as to leave a remaining periodic structure, diagrammatically shown on figure 1 with references 15 and 16. The cladding layer 6 is then terminated by burying the periodic structure with a high index inside a material with a lower index, for example InP as for the spacing layer. This etching technique has the advantage of giving good control over the thickness and geometry of periodic structures 15 and 16, and therefore the coupling coefficient of each grating with guided mode.

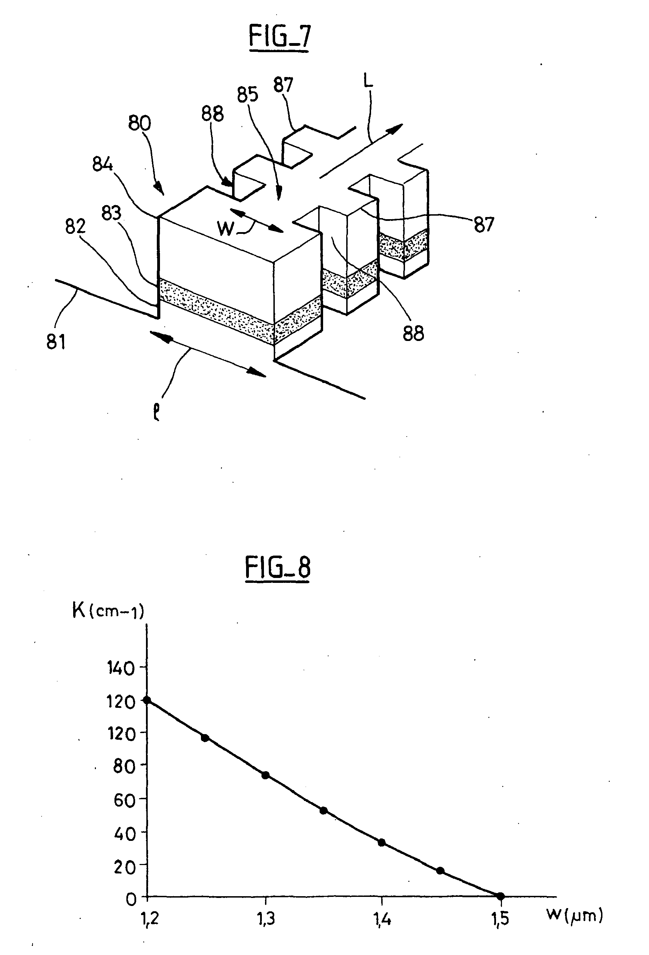

There are other ways of making gratings, for example by etching them in the guide layer 4 as illustrated on figure 7.

In each Bragg section, the guide layer 4 is made of a material chosen so that its effective index Ni depends on the density of the fillers contained in it. This density can be modified by current injection to modify the Bragg wavelength ai. The period A2 is different from the period A1, and preferably larger than the period A1. Thus, each Bragg section has a Bragg wavelength ai that is adjustable within a given range, each time corresponding to an adjustment interval of the laser emission wavelength, as will be explained below.

The guide layer 4 of a Bragg section may be made of a solid material, for example InGaAsP. This layer is designed to confine a very substantial part of the guided mode, for example at least 70% of the light, so as to facilitate tuneability of the laser. As a variant, the guide layer 4 of Bragg sections may be composed of a sequence of quantum wells separated by layers forming a potential barrier.

The outside face of the active section 3 comprises a reflector 20 that is not selective in wavelength and forms a Fabry-Pérot cavity with the Bragg sections 1 and 2, including the active section 3. With a first type of laser, the laser power created in the cavity is extracted essentially through this external face that is then made semi-reflecting. For example, its reflectivity may be around 1.5 to 5% so as to enable laser oscillation and also emission of the laser wave outside the component. The end of the Bragg section 2 opposite the active section forms a second external face 21 of the component that is made strongly anti-reflecting to prevent the formation of parasitic cavity modes.

Laser oscillation is possible for a set of longitudinal resonant modes (Fabry-Pérot modes), for which the wavelengths are imposed by the optical length of the cavity. An oscillation occurs in one of these modes if sufficient tuning occurs between its wavelength and the Bragg wavelength ai. Since the two Bragg sections 1 and 2 are put in series, two oscillating modes each corresponding to the Bragg wavelength of one of the sections can be superposed. A single-mode laser, in other words that emit laser power over a single spectral band, can be made by designing the two Bragg sections such that the reflectivity of section 2 is greater than the reflectivity for section 1 over the entire adjustment range of the current I2, at least for one value of current in the Bragg section 1 called the default value. For example, the default value may be I1=0. In other words, if there is no current I1, losses suffered by the oscillating mode between the grating 16 and the reflector 20 are lower than losses suffered by the oscillating mode between the grating 15 and the reflector 20. Thus, laser emission occurs in the spectral band corresponding to the Bragg wavelength a2. This difference in reflectivity is obtained due to the design of gratings 15 and 16, and particularly the choice of their corresponding lengths and coupling coefficients.

In general, to achieve this, it is preferable for the coupling coefficient $\kappa_2$ of the grating 16 to be greater than the coupling coefficient $\kappa_1$ of the grating 15 and for the length L2 of the Bragg section 2 to be greater than the length L1 of the Bragg section 1. Remember that the coupling coefficient of a grating is defined by the formula:

$$K = 2\Delta N/a$$

where ΔN denotes the difference between the effective index seen by guided mode in a tooth of the grating and the effective index seen by guided mode outside teeth in the grating, and a denotes the operating wavelength. There are many ways of adjusting the coupling coefficient of the grating, for example by adjusting the thickness of the grating layer, the grating filling factor, or modifying the geometry of the teeth, for example by varying a transverse dimension of etched structures. One particular technique that could be used for this purpose is described below with reference to figure 7.

Each Bragg section is preferably sufficiently long to guarantee sufficient spectral selectivity, in other words a side-mode suppression ratio (SMSR) greater than 20dB, and preferably greater than 40dB. Conversely, the length of Bragg sections is chosen to be below a limit at which problems related to spontaneous emission, absorption or mode skips could occur. Non-limitative examples of appropriate designs are given below.

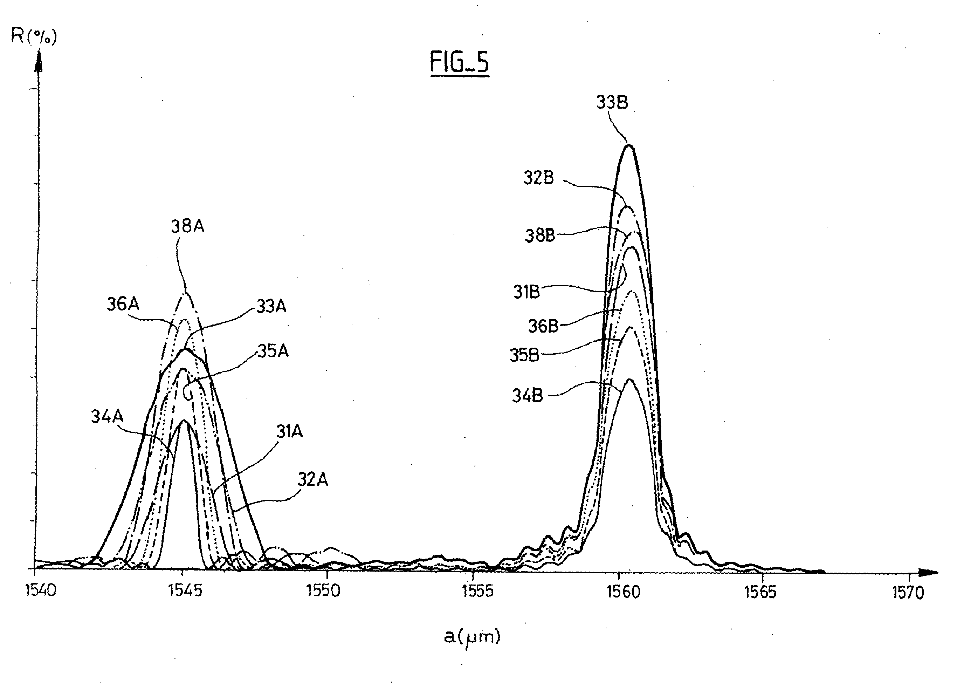

Figure 5 represents the spectral reflectivity R of the composite reflector device formed from the two Bragg sections installed in series, this reflectivity being calculated at the inlet to the Bragg section 1 as a function of the wavelength a, for several example sizes of gratings 15 and 16 mentioned in table 1, for I1=I2=0. The curve 30+j corresponds to example j in table 1. In each case, it is composed of a first peak denoted by index A at the Bragg wavelength a1, and a second peak denoted by index B at the Bragg wavelength a2. In table 1, R1 denotes the maximum value of the first peak and R2 denotes the maximum value of the second peak, for each example. Some examples in the table are not shown in figure 5. The examples in table 1 show that a ratio R1/R2 less than 1 can be obtained with several grating size choices. Those skilled in the art will easily find other sizes satisfying this condition. Preferably, the ratio R1/R2 is chosen to be less than 0.85 at zero current.

As can be seen on figure 5, the spectral selectivity of the first peak varies inversely with the length L1. It will be seen that the coupling coefficient □$_i$ of each grating is given as a constant because in practice, its variation is negligible over the entire adjustment range of the Bragg wavelength ai. In other words, this coupling exists even when no current is injected into Bragg sections. Furthermore, the coupling coefficient may increase slightly with current injection. Thus, it is possible that the relation R2>R1 is obtained in practice for an entire adjustment range of 11. However, it is only necessary if this relation is obtained for at least one value of 11, preferably a low or zero value.

Table 1: reflectivity of Bragg sections for different example grating sizes

| Example | $\kappa_1$ (cm$^{-1}$) | $L_1$ (pm) | $\kappa_2$ (cm$^{-1}$) | $L_2$($\mu$m) | R1 (%) | R2 (%) | R1/R2 |
|---|---|---|---|---|---|---|---|
| 1 | 20 | 177 | 80 | 500 | 16 | 38 | 0.42 |
| 2 | 30 | 137 | 80 | 500 | 21 | 42 | 0.50 |
| 3 | 40 | 107 | 100 | 500 | 23 | 50 | 0.46 |
| 4 | 10 | 400 | 60 | 500 | 16 | 20 | 0.80 |
| 5 | 15 | 300 | 60 | 500 | 21 | 25 | 0.84 |
| 6 | 20 | 250 | 60 | 500 | 26 | 29 | 0.90 |
| 7 | 25 | 200 | 60 | 500 | 27 | 33 | 0.82 |
| 8 | 30 | 170 | 60 | 500 | 29 | 35 | 0.83 |
| 9 | 60 | 107 | 100 | 500 | 42 | 54 | 0.78 |

For example, the reflectivity values R1 and R2 may be measured by analysing the radiation emitted by the source when section 3 receives a current smaller than the laser limit.

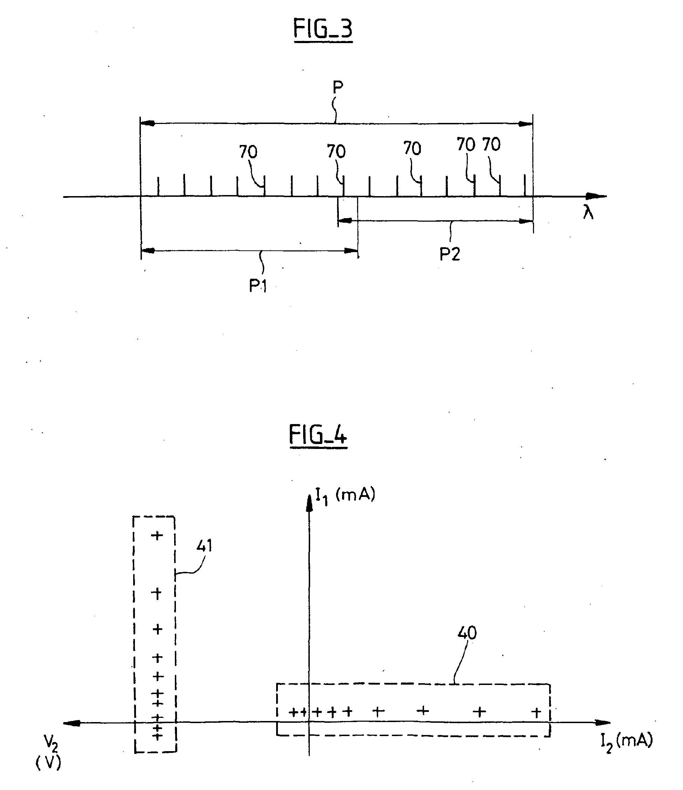

We will now describe operation of the laser in figure 1, with reference to figures 3 and 4.

In a first operating mode, I1 is kept constant at the default value, for example I1=0. As explained, the laser radiation is obtained for the mode with the lowest losses, therefore at a wavelength corresponding approximately to the Bragg wavelength a2. This wavelength can be adjusted over an entire spectral interval P2 by adjusting the current 12, like a conventional DBR laser. For example, the Bragg section 2 may provide a spectral interval greater than 10 nm. In this operating mode, the current I1 may be kept constant. Laser control is therefore very simple.

In a second operating mode, the current I2 is eliminated and the module 26 applies a negative voltage V2 between electrodes 10 and 7, which makes the Bragg section 2 highly absorbent due to the Franz-Keldysh effect or any other similar physical effect. For example V2=-2V. In this case, the second peak in figure 5 is strongly attenuated and the laser radiation is obtained at a wavelength corresponding approximately to the Bragg length a1. This wavelength may be adjusted over a spectral interval P1 by adjusting the current I1, like a conventional DBR laser. For example, the Bragg section 1 may provide a spectral interval larger than 10 nm. In this operating mode, the voltage V2 may be kept constant. Control of the laser is again very simple.

Figure 4 qualitatively illustrates control signals applied to the laser in the two operating modes. The cluster of points 40 corresponds to the first operating mode. In this example, the current I1 is slightly positive, for example a few mA, to assure that the Bragg wavelength a1 is outside the interval P2. The current I2 scans the entire interval P2, for example for values between 0 and 70 mA approximately. The cluster of points 41 corresponds to the second operating mode. The voltage V2 has a polarity opposite to the current I2 of the first operating mode. The current I1 can scan the entire interval P1, for example for values of between 0 and approximately 70 mA.

For example, periods A1 and A2 may be chosen such that the laser is tuneable to band C. To achieve this, the Bragg section 1 offers a tuning interval P1 equal to about 16 nm between 1530 and 1546 nm in the second operating mode, and the Bragg section 2 offers a complementary tuning interval P2 equal to about 16 nm between 1545 and 1561 nm in the first operating mode. The slight overlap between intervals P1 and P2, for example over 1 nm, can be used to obtain a continuous tuning interval P covering 30 nm. Obviously, the laser can be adapted to other spectral intervals with or without overlap, by a corresponding choice of periods A1 and A2 and the component materials.

Detailed example 1

A laser source is made like that shown in figure 1, in which the properties of Bragg sections 1 and 2 are as follows: $\kappa1=20cm^{-1}$, $L1=177\mu m$, $\kappa2=80cm^{-1}$ and $L2=300\mu m$. The wavelength of the active section 3 is approximately 600 $\mu m$. Control signals are applied so as to reach the operating points mentioned in table 2. An emitted power spectrum is measured at each point. A narrow spectral line is obtained in each case. For operating points corresponding to the first operating mode, a 13.75 nm interval is scanned between about 1547 nm and about 1561 nm in increments of about 1.6nm. The SMSR is close to 40 dB. For operating points corresponding to the second operating mode, a 15.15 nm interval is scanned between about 1532 nm and about 1547 nm in increments of about 1.6 nm. The SMSR is close to 20 dB. This rate may be increased by increasing L1, as can be seen on figure 5. The spectral width of the first peak 34A, 35A, 36A or 38A becomes lower as the length L1 is increased.

Table 2: laser operating points

| First mode | I1 (mA) | -0.2. | -0.2 | -0.2 | -0.2 | -0.2 | -0.2 | -0.2 | -0.2 | -0.2 | |
|---|---|---|---|---|---|---|---|---|---|---|---|
| | I2 (mA) | -0.7 | -0.3 | 0.7 | 1.4 | 3 | 7 | 12 | 20 | 30 | |
| Second mode | I1 (mA) | -0.7 | -0.2 | 0.3 | 1 | 2 | 4 | 8 | 15 | 25 | 40 |
| | V2 (V) | -2 | -2 | -2 | -2 | -2 | -2 | -2 | -2 | -2 | -2 |

Detailed example 2

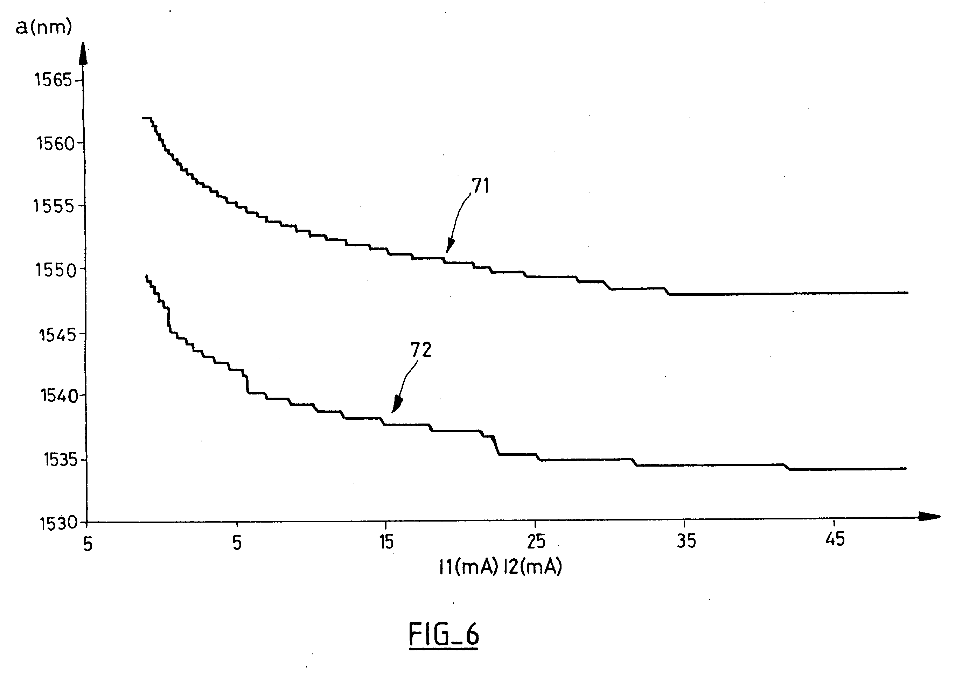

A laser source according to figure 1 is made in which the properties of Bragg sections 1 and 2 are as follows: $\kappa1=20cm^{-1}$, $L1=167\mu m$, $\kappa2=80cm^{-1}$ and $L2=525\mu m$. Figure 6 shows tuning curves corresponding to the two operating modes. Curve 71 represents the emission wavelength as a function of the current intensity 12 in the Bragg section 2, the current 11 being kept at 0. The curve 72 represents the emission wavelength as a function of the intensity of the current I1 in the Bragg section 1, a constant negative voltage V2=-1.5V being applied to the Bragg section 2.

The laser source in the embodiment in figure 1 may be designed to cover practically the entire band C, namely about 35 nm. It is very easy to control in comparison with other lasers that can be tuned over such a wide spectral interval. Each time, the wavelength is adjusted by controlling the current in one of the Bragg sections, the other section being kept unchanged. The wavelength may be adjusted quickly particularly in comparison with laser sources with thermal adjustment. Furthermore, these results are obtained with a component with a satisfactory length, for example shorter than 1500$\mu m$ and preferably around 1200 to 1300$\mu m$. Consequently, risks of mode skips and non-linear interactions between Fabry-Pérot modes are reduced, which could make the characteristics of the source unstable and lead to hysteresis phenomena. The laser source is therefore resistant to parasitic cavity phenomena and inaccuracies in control signals.

Figure 7 shows a Bragg section made using a particular process, to make a wave guide carrying a grating etched on the sides of the wave guide. The coupling coefficient of the grating may be adjusted by varying the dimensions of the teeth of the grating. The arrow L represents the longitudinal direction of the laser cavity. A projecting structure 80 in the form of a ribbon with width $\ell$ is formed on a substrate 81, for example made of InP material. The structure 80 comprises three successive layers, a spacing layer 82 made of a low index material, a guide layer 83 made of a high index material, and an overlap layer 84 made of a low index material. The grating is etched in the structure 80 along its two longitudinal edges 87, periodically over the entire thickness of the structure 80. The ribbon supporting the grating is preferably made in a single etching step, using a mask containing indentations. In the example shown, two symmetric notches with a rectangular cross-section 88 are made for each period, leaving the median zone 85 of the structure 80 over a width w. In a second step, the etched structure as shown on figure 7 is buried in the material forming a cladding layer (not shown), for example InP. Figure 8 represents the coupling coefficient κ of the grating thus obtained as a function of the width w, for ℓ = 1.5μm. This manufacturing process makes it possible to adjust the coupling coefficient κ fairly precisely.

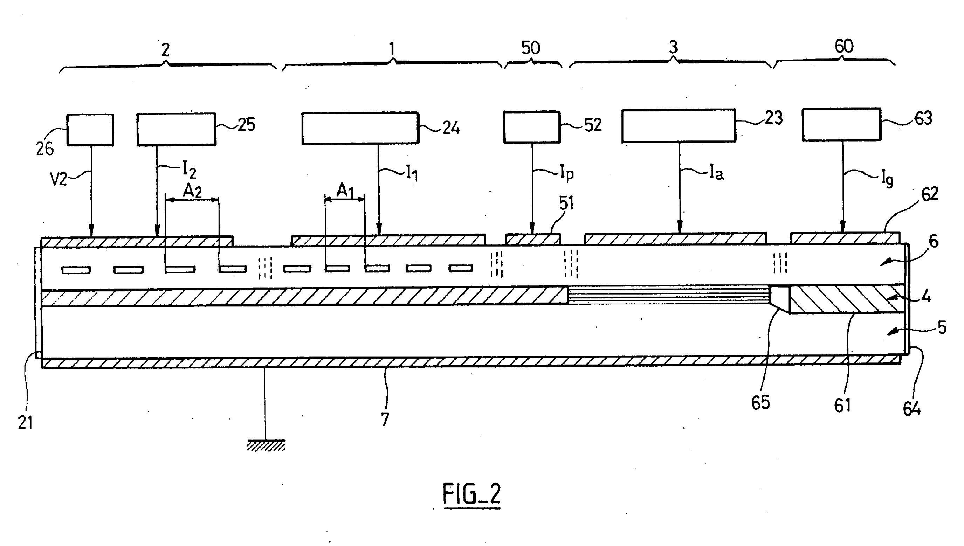

Several variants of the laser sources described above will now be described with reference to figure 2. Identical elements or elements similar to those in Figure 1 are denoted by the same numbers and are not described again. For conciseness, several different modifications are all introduced on figure 2. However, each of these modifications could be introduced independently of the others, because they are not indispensable for each other.

A first modification introduced on figure 2 is the presence of a phase section 50 in the semiconducting structure between the active section 3 and the Bragg section 1. The phase section 50 has a multi-layer structure, for example identical to the Bragg section but without a grating. An electrode 51 is provided adjacent to the phase section 50. An electrical control module 52 injects a controlled current IP into the phase section 50, so as to continuously tune the emission wavelength. The current Ip modifies the optical length of the cavity and therefore produces an adjustable offset of the comb of Fabry-Pérot mode wavelengths without influencing the Bragg wavelength of sections 1 and 2. The length of the phase section 50 is not very penalising. For example, this length is about 50 to 100μm.

A second modification is the presence of a power section 60 or 160 to control the power emitted by the laser. This section can control the power separately from tuning of the wavelength. The power section can thus act as an optical gate. The presence of a power section has the advantage of lowering the set power inside the cavity. The power section is arranged between the cavity and the output facet of the laser radiation and for example consists of a semiconductor optical amplifier.

According to a first embodiment shown on Figure 2, the power section 60 is located on the side of the active section 3. In the power section 60, an active layer 61 is made as a guide layer 4, to produce a stimulated amplification of the radiation output from the cavity. An electrode 62 is provided adjacent to the power section 60. An electrical control module 63 is used to inject a controlled current Ig into the power section 60 so as to control the output power. The external facet of the section 60 is provided with an anti-reflecting coating 64. The laser cavity is then delimited by a reflector 65 arranged in the guide layer 4 between the active section 3 and the power section 60. The reflector 65 may for example be an on-chip mirror etched on the semiconductor crystal.

According to one alternative embodiment shown in figure 1, the power section 160 with a similar structure is placed on the same side as the Bragg section 2. In this case, the external facet 20 of the active section 3 is strongly reflecting. In this case, the absorptivity of the Bragg section 2 must remain moderate. To achieve this, the value of the voltage V2 in the second operating mode may be adjusted to a lower level, for example around -0.5V. In the second operating mode, all that is necessary is that the absorption generated in the Bragg section 2 inverts the relation between the reflectivity peaks created by the two Bragg sections, in other words the reflectivity of the Bragg section 1 dominates.

Regardless of the side from which laser power is extracted from the cavity, one or several other components may be coupled each time at the output from the cavity, for example such as an amplifier like that described above, or a photodetector or a modulator or other.

The electric control modules 23, 24, 25, 26, 52 and 63 may be made in many forms. For example, a single electrical circuit can perform the functions of several modules. Preferably, a control unit (not shown) controls all electrical control modules centrally. Such a control unit typically comprises a microprocessor, a memory and an output interface to transmit commands to modules. In particular it may be programmed to tune the laser selectively to a plurality of predefined spectral bands illustrated qualitatively by lines 70 on figure 3 that for example correspond to a standard gate.

The different variants explained with reference to figure 2 essentially have the same advantages as the first embodiment. In summary, a laser source is obtained that can be tuned over a spectral interval wider than an ordinary DBR laser with a single Bragg section, and keeping a control process just as simple as for an ordinary DBR laser. The reliability of the source obtained and the simplicity of its manufacturing make it suitable for industrial production or for applications such as optical telecommunications or other applications.

This source is particularly advantageous in a fast switching application, for example for packet switching or circuit switching. The emission wavelength can be switched in a few nanoseconds. The phase section can also be used to compensate for any slow wavelength drift due to electrical heating.

To further increase the spectral interval accessible by the source, one or several additional Bragg sections could be added beyond the Bragg section 2, with continuously increasing resonant reflectivity. For each additional section, a negative voltage source is then provided and controlled to selectively provoke substantial absorption and a positive current source to adjust the corresponding Bragg wavelength. The control process for such a source is based on the same principles as described above: absorption is created in none or in one or in several Bragg sections to allow the reflectivity of a selected Bragg section to dominate. The wavelength emitted by the source corresponds to this selected wave section and may be adjusted within a relatively wide interval by means of the corresponding current.

Although the invention has been described with reference to several particular embodiments, it is obvious that it is not in any way limited to these embodiments and that it includes all technical equivalents of the means described and combinations of them, provided that they are within the scope of the invention.

**Claims**

1.  Laser emission device comprising a first wave guide portion (3) including an optical amplification means to produce a stimulated emission of light, a second wave guide portion coupled to the first wave guide portion,
    a first reflecting unit coupled to the second wave guide portion in guided mode so as to reflect light from the second wave guide portion to the first wave guide portion,
    a second reflecting unit (20) arranged so as to reflect light in the opposite direction from the first reflecting unit to form a cavity,
    said first reflecting unit including a first distributed reflector (15) with a first spatial period capable of receiving a first electrical control signal (I1) and a second distributed reflector (16) with a second spatial period capable of receiving a second electrical control signal (12), said first distributed reflector being located between the second distributed reflector and the first wave guide portion,
    wherein said first reflecting unit has a first resonant reflectivity (33A) over a first spectral band adjustable in a first spectral interval (P1) by means of the first electrical control signal and a second resonant reflectivity (33B) over a second spectral band adjustable in a second spectral interval (P2) by means of the second electrical control signal, the second resonant reflectivity being significantly higher than the first resonant reflectivity, at least for a second electrical control signal variation range corresponding to the second spectral interval, and **characterized b**y the fact that it comprises a controlled extinguishing means (26) used to selectively generate optical absorption at the second distributed reflector.

2.  Device set forth in claim 1, **characterised by** the fact that said extinguishing means includes a voltage source (26) to apply a voltage (V2) with a polarity opposite to the polarity of the second control signal (12) at the second distributed reflector.

3.  Device set forth in either claim 1 or 2, **characterised by** the fact that a coupling coefficient of the second distributed reflector with guided mode in the second wave guide portion (4) is greater than a coupling coefficient of the first distributed reflector with guided mode in the second wave guide portion.

4.  Device set forth in one of claims 1 to 3, **characterised by** the fact that the second spatial period (A2) is greater than the first spatial period (A1).

5.  Device set forth in one of claims 1 to 4, **characterised by** the fact that it comprises an electrical adjustment means (24) capable of generating the first electrical control signal to adjust the position of the first spectral band in the first spectral interval.

6.  Device set forth in claim 5, **characterised by** the fact that the first electrical signal is a controlled current.

7.  Device set forth in one of claims 1 to 6, **characterised by** the fact that it comprises an electrical adjustment means (25) capable of generating the second electrical control signal to adjust the position of the second spectral band in the second spectral interval.

8.  Device set forth in claim 7, **characterised by** the fact that the second electrical signal is a controlled current.

9.  Device set forth in claims 5 and 7 taken together, **characterised by** the fact that it comprises a control unit capable of selectively controlling the extinguishing means and electrical adjustment means such that in a first operating mode (41), the extinguishing means is active and the electrical adjustment means of the first spectral band adjusts the position of the first spectral band to a wavelength to be emitted located in the first spectral interval, and in a second operating mode (40), the extinguishing means is inactive and the electrical adjustment means of the second spectral band adjusts the position of the second spectral band to a wavelength to be emitted located in the second spectral interval.

10. Device set forth in one of claims 1 to 9, **characterised by** the fact that the first and second spectral intervals (P1, P2) are approximately adjacent or overlap.

11. Device set forth in one of claims 1 to 10, **characterised by** the fact that the second wave guide portion comprises

**EP 1 850 429 B1**

a guide layer (83) made of a material with a high index between two layers made of a material with a lower index (82, 84), at least one of said first and second distributed reflectors (15, 16) comprising an etched grating in the guide layer along its two longitudinal edges (87).

12. Device set forth in one of claims 1 to 11, **characterized in that** the second resonant reflectivity is significantly higher than the first resonant reflectivity at a zero value of the first electrical control signal.

13. Device set forth in one of claims 1 to 12, **characterized in that** the second reflecting unit (20) is not selective in wavelength.

**Patentansprüche**

1. Laseremissionsvorrichtung, umfassend
einen ersten Wellenleiterabschnitt (3) mit einem optischen Verstärkungsmittel zum Erzeugen einer stimulierten Emission von Licht,
einen zweiten Wellenleiterabschnitt, welcher an den ersten Wellenleiterabschnitt gekoppelt ist,
eine erste Reflexionseinheit, welche an den zweiten Wellenleiterabschnitt im Leitungsmodus gekoppelt ist, um Licht von dem zweiten Wellenleiterabschnitt auf den ersten Wellenleiterabschnitt zu reflektieren,
eine zweite Reflexionseinheit (20), welche dazu ausgelegt ist, das Licht in der im Verhältnis zur ersten Reflexiönseinheit entgegengesetzten Richtung zu reflektieren, um einen Hohlraum zu bilden,
wobei die besagte erste Reflexionseinhett einen ersten verteilten Reflektor (15) mit einer ersten räumlichen Periode, welcher fähig ist, ein erstes elektrisches Steuersignal (I1) zu empfangen, und einen zweiten verteilten Reflektor (16) mit einer zweiten räumlichen Periode, welcher fähig ist, ein zweites elektrisches Steuersignal (I2) zu empfangen, umfasst, wobei der besagte erste verteilte Reflektor zwischen dem zweiten verteilten Reflektor und einem ersten Wellenleiterabschnitt angeordnet ist,
wobei die besagte erste Reflexionseinheit eine erste resonante Reflektivität (33A) über ein erstes Spektralband, welches anhand des ersten elektrischen Steuersignals in einem ersten Spektralintervall (P1) regelbar ist, und eine zweite resonante Reflektivität (33B) über ein zweites Spektralband, welches anhand des zweiten elektrischen Steuersignals in einem zweiten Spektralintervall (P2) regelbar ist, aufweist, wobei die zweite resonante Reflektivität deutlich höher als die erste resonante Reflektivität, zumindest für einen dem zweiten Spektralintervall entsprechenden Variations bereich des zweiten elektrischen Steuersignal, ist, und **dadurch gekennzeichnet, dass** sie ein gesteuertes Löschmittel (26) umfasst, welches für das selektive Erzeugen einer optischen Absorption an dem zweiten verteilten Reflektor verwendet wird.

2. Vorrichtung nach Anspruch 1, **dadurch gekennzeichnet, dass** das besagte Löschmittel eine Spannungsquelle (26) umfasst, um an dem zweiten verteilten Reflektor eine Spannung (V2) anzulegen, deren Polarität zu der Polarität des zweiten Steuersignals (12) entgegengesetzt ist.

3. Vorrichtung nach einem beliebigen der Ansprüche 1 oder 2, **dadurch gekennzeichnet**, ein Kopplungskoeffizient des zweiten verteilten Reflektors mit Leitungsmodus in dem zweiten Wellenleiterabschnitt (4) größer als ein Kopplungskoeffizient des ersten verteilten Reflektors mit Leitungsmodus in dem ersten Wellenleiterabschnitt ist.

4. Vorrichtung nach einem der Anspruche 1 bis 3, **dadurch gekennzeichnet, dass** die zweite räumliche Periode (A2) größer als die erste räumliche Periode (A1) ist.

5. Vorrichtung nach einem der Ansprüche 1 bis 4, **dadurch gekennzeichnet, dass** sie ein elektrisches Justiermittel (24) umfasst, welches fähig ist, das erste elektrische Steuersignal zu erzeugen, um die Position des ersten Spektralbands in dem ersten Spektralintervall zu justieren.

6. Vorrichtung nach Anspruch 5, **dadurch gekennzeichnet, dass** das erste elektrische Signal ein gesteuerter Strom ist.

7. Vorrichtung nach einem der Ansprüche 1 bis 6, **dadurch gekennzeichnet, dass** sie ein elektrisches Justiermittel (25) umfasst, welches fähig ist, das zweite elektrische Steuersignal zu erzeugen, um die Position des zweiten Spektrasbands in dem zweiten Spektralintervall zu justieren.

8. Vorrichtung nach Anspruch 7, **dadurch gekennzeichnet, dass** das zweite elektrische Signal ein gesteuerter Strom

9

ist.

9. Vorrichtung nach den gemeinsam genommenen Ansprüchen 5 und 7, **dadurch gekennzeichnet, dass** sie eine Steuereinheit umfasst, welche fähig ist, das Löschmittel und das elektrische justiermittel selektiv derart zu steuern, dass in einem ersten Betriebsmodus (41) das Löschmittel aktiv ist und das elektrische Justiermittel des ersten Spektralbands die Position des ersten Spektralbands auf eine zu emitierende Wellenlänge in dem ersten Spektral- interval justiert, und in einem zweiten Betriebsmodus (40) das Löschmittel aktiv ist und das elektrische Justiermittel des zweiten Spektralbands die Position des zweiten Spektralbands auf eine zu emitierende Wellenlänge in dem zweiten Spektralintervall justiert.

10. Vorrichtung nach einem der Ansprüche 1 bis 9, **dadurch gekennzeichnet, dass** das erste und das zweite Spektralintervall (P1, P2) annähernd benachbart sind oder sich überschneiden.

11. Vorrichtung nach einem der Ansprüche 1 bis 10, **dadurch gekennzeichnet, dass** der zweite Wellenleiterabschnitt eine Leiterschicht (83) aus einem Material mit einem höheren Index zwischen zwei Schichten aus einem Material mit einem niedrigeren Index (82, 84) umfasst, wobei zumindest entweder der erste oder der zweite verteilte Reflektor (15, 16) ein geätztes Gitter in der Leiterschicht entlang seiner beiden Längsränder (87) umfasst.

12. Vorrichtung nach einem der Anspruche 1 bis 11, **dadurch gekennzeichnet, dass** bei einem Nullwert des ersten elektrischen Steuersignals die zweite resonante Reflektivität deutlich höher als die erste resonante Reflektivität.

13. Vorrichtung nach einem der Ansprüche 1 bis 12, **dadurch gekennzeichnet**, das die zweite Reflexionseinheit (20) in der Wellenlänge nicht selektiv ist.

## Revendications

1. Dispositif d'émission laser, comprenant :

    - une première portion de guide d'onde (3) comprenant un moyen d'amplification optique pour produire une émission de lumière stimulée,
    - une deuxième portion de guide d'onde couplée à la première portion de guide d'onde,
    - une première unité réfléchissante couplée à la deuxième portion de guide d'onde en mode guidé de façon à réfléchir la lumière de la deuxième portion de guide d'onde vers la première portion de guide d'onde,
    - une deuxième unité réfléchissante (20) disposée de manière à réfléchir la lumière dans la direction opposée à la première unité réfléchissante pour former une cavité,
    - ladite première unité réfléchissante comprenant un premier réflecteur à répartition (15) avec une première période spatiale capable de recevoir un premier signal de commande électrique (I1) et un deuxième réflecteur à répartition (16) avec une deuxième période spatiale capable de recevoir un deuxième signai de commande électrique (I2), ledit premier réflecteur à répartition étant situé entre le deuxième réflecteur à répartition et la première portion de guide d'onde,
    - dans lequel ladite première unité réfléchissante a une première réflectivité résonante (33A) sur une première bande spectrale réglable dans un premier intervalle spectral (P1) au moyen du premier signal de commande électrique et une deuxième réflectivité résonante (33B) sur une deuxième bande spectrale réglable dans un deuxième intervalle spectral (P2) au moyen du deuxième signal de commande électrique, la deuxième réflectivité résonante étant significativement supérieure à la première réflectivité résonnante, au moins pour une deuxième plage de variation de signal de commande électrique correspondant au deuxième intervalle spectral, et **caractérisé par le fait qu'**il comprend un moyen d'extinction contrôlé (26) utilisé pour générer de façon sélective l'absorption optique au niveau du deuxième réflecteur à répartition.

2. Dispositif selon la revendication 1, **caractérisé par le fait que** ledit moyen d'extinction comprend une source de tension (26) pour appliquer une tension (V2) d'une polarité opposée à la polarilé du deuxième signal de contrôle (I2) sur le deuxième réflecteur à répartition.

3. Dispositif selon la revendication 1 ou 2, **caractérisé par le fait qu'**un coefficient de couplage du deuxième réflecteur à répartition en mode guidé de la deuxième portion de guide d'onde (4) est supérieur à un coefficient de couplage du premier réflecteur à répartition en mode guidé de la deuxième portion de guide d'onde.

**4.** Dispositif selon l'une quelconque des revendications 1 à 3, **caractérisé par le fait que** la deuxième période spatiale (A2) est supérieure à la première période spatiale (A1).

**5.** Dispositif selon l'une quelconque des revendications 1 à 4, **caractérisé par le fait qu'**il comprend un moyen de réglage électrique (24) capable de générer le premier signal de commande électrique pour régler la position de la première bande spectrale dans le premier intervalle spectral.

**6.** Dispositif selon la revendication 5, **caractérisé par le fait que** le premier signal électrique est un courant contrôlé.

**7.** Dispositif selon l'une quelconque des revendications 1 à 6, **caractérisé par le fait qu'**il comprend un moyen de réglage électrique (25) capable de générer le deuxième signal de commande électrique pour régler la position de la deuxième bande spectrale dans le deuxième intervalle spectral.

**8.** Dispositif selon la revendication 7, **caractérisé par le fait que** le deuxième signal électrique est un courant contrôlé.

**9.** Dispositif selon les revendications 5 et 7 considérées ensemble, **caractérisé par le fait qu'**il comprend une unité de commande capable de contrôler de façon sélective le moyen d'extinction et le moyen de réglage électrique de telle sorte que dans un premier mode de fonctionnement (41), le moyen d'extinction est actif et le moyen de réglage électrique de la première bande spectrale règle la position de la première bande spectrale sur une longueur d'onde à émettre située dans le premier intervalle spectral, et dans un deuxième mode de fonctionnement (40), le moyen d'extinction est inactif et le moyen de réglage électrique de la deuxième bande spectrale règle la position de la deuxième bande spectrale sur une longueur d'onde à émettre située dans le deuxième intervalle spectral.

**10.** Dispositif selon l'une quelconque des revendications 1 à 9, **caractérisé par le fait que** les premier et deuxième intervalles spectraux (P1, P2) sont approximativement adjacents ou se chevauchent,

**11.** Dispositif selon l'une quelconque des revendications 1 à 10, **caractérisé par le fait que** la deuxième portion de guide d'onde comprend une couche de guidage (83) faite d'un matériau à indice élevé entre deux couches faites d'un matériau à indice plus faible (82, 84), au moins l'un desdits premier et deuxième réflecteurs à répartition (15, 16) comprenant un réseau de diffraction gravé dans la couche de guidage le long de ses deux bords longitudinaux (87).

**12.** Dispositif selon l'une quelconque des revendications 1 à 11, **caractérisé en ce que** la deuxième réflectivité résonante est significativement, supérieure à la première réflectivité résonante à une valeur zéro du premier signal de commande électrique,

**13.** Dispositif selon l'une des revendications 1 à 12, **caractérisé en ce que** la deuxième unité réfléchissante (20) n'est pas sélective en longueur d'onde.

FIG_1

EP 1 850 429 B1

EP 1 850 429 B1

FIG_2

## FIG_3

## FIG_4

FIG.5

EP 1 850 429 B1

EP 1 850 429 B1

a(nm)

1565 —

1560 —

1555 —

1550 —

1545 —

1540 —

1535 —

1530 —

71

72

5          5          15          25          35          45

I1(mA) I2(mA)

FIG_6

## FIG_7

## FIG_8

**EP 1 850 429 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4885753 A
- FR 2737942 A
- GB 2381123 A